# EUROPEAN PATENT APPLICATION

(11) **EP 4 287 275 A1**
(43) Date of publication of application: **06.12.2023**
(21) Application number: 22767360.5
(22) Date of filing: 18.02.2022
(51) Int. Cl.: H01L 31/074, H01L 31/0224, H01L 31/078, H01L 31/0687, H01L 31/18, H01L 51/42, H01L 51/44

(54) **SOLAR CELL AND METHOD FOR MANUFACTURING SAME**

(30) Priority: 10.03.2021 KR 20210031592
(71) Applicant: Jusung Engineering Co., Ltd., Gwangju-si, Gyeonggi-do 12773 (KR)
(72) Inventor: KIM, Jae Ho, Gwangju-si Gyeonggi-do 12773 (KR); HWANG, Chul Joo, Gwangju-si Gyeonggi-do 12773 (KR)
(74) Representative: AWA Sweden AB
(86) International application number: PCT/KR2022/002445
(87) International publication number: WO 2022/191464

(57) **Abstract**

The present invention provides a solar cell, including: a semiconductor substrate; a first semiconductor layer provided on one surface of the semiconductor substrate; a second semiconductor layer provided on one surface of the first semiconductor layer; a third semiconductor layer provided on one surface of the second semiconductor layer; a first transparent conductive layer provided on one surface of the third semiconductor layer; and a first electrode provided on one surface of the first transparent conductive layer, wherein the second semiconductor layer includes a p-type semiconductor layer, and the third semiconductor layer includes a p+-type semiconductor layer including W, and a method of manufacturing the solar cell.

## Description

### [Technical Field]

The present invention relates to a solar cell, and particularly, to a solar cell using a semiconductor substrate.

### [Background Art]

A solar cell using a semiconductor substrate is manufactured by forming a plurality of semiconductor layers on a semiconductor substrate.

For example, a solar cell of the related art includes a p-type semiconductor layer formed on one surface of a semiconductor substrate, an n-type semiconductor layer formed on the other surface of the semiconductor substrate, and a transparent conductive layer formed on the p-type semiconductor layer.

In the solar cell of the related art, a p-type amorphous silicon layer is used as the p-type semiconductor layer, and in this case, because a bandgap of p-type amorphous silicon is large, there is a problem where an open-circuit voltage (Voc) of the solar cell is low.

### [Disclosure]

### [Technical Problem]

The present invention is devised to solve the above-described problem and is for providing a solar cell and a method of manufacturing the same, in which a p+-type semiconductor layer is additionally formed between a p-type semiconductor layer and a transparent conductive layer, thereby increasing an open-circuit voltage.

### [Technical Solution]

To accomplish the above-described objects, the present invention provides a solar cell including: a semiconductor substrate; a first semiconductor layer provided on one surface of the semiconductor substrate; a second semiconductor layer provided on one surface of the first semiconductor layer; a third semiconductor layer provided on one surface of the second semiconductor layer; a first transparent conductive layer provided on one surface of the third semiconductor layer; and a first electrode provided on one surface of the first transparent conductive layer, wherein the second semiconductor layer includes a p-type semiconductor material, and the third semiconductor layer includes a p-type semiconductor material including tungsten (W).

A bandgap of the third semiconductor layer may be less than a bandgap of the second semiconductor layer, and a valence band maximum energy level of the third semiconductor layer may be lower than a valence band maximum energy level of the second semiconductor layer.

The first transparent conductive layer may be formed of a transparent oxide film including indium.

The first semiconductor layer may be formed of an intrinsic amorphous silicon layer.

The solar cell may further include: a fourth semiconductor layer provided on the other surface of the semiconductor substrate; a fifth semiconductor layer provided on a surface of the fourth semiconductor layer; a second transparent conductive layer provided on a surface of the fifth semiconductor layer; and a second electrode provided on a surface of the second transparent conductive layer, wherein the fifth semiconductor layer may include an n-type semiconductor material including tin (Sn).

The fourth semiconductor layer may be formed of an intrinsic amorphous silicon layer, an n-type amorphous silicon layer may be further provided between the fourth semiconductor layer and the fifth semiconductor layer, a bandgap of the fifth semiconductor layer may be greater than a bandgap of the n-type amorphous silicon layer, and a conduction band minimum energy level of the fifth semiconductor layer may be higher than a conduction band minimum energy level of the n-type amorphous silicon layer.

A thickness of the fifth semiconductor layer may be formed within a range of 10 Å to 100 Å, and a thickness of the second transparent conductive layer may be formed within a range of 100 Å to 500 Å.

The second transparent conductive layer may be formed of a transparent oxide film including indium, and a concentration of indium in the transparent oxide film may be within a range of 1 at% to 5 at%.

The first transparent conductive layer may be formed of a transparent oxide film including indium, and a content of indium included in the first transparent conductive layer may be higher than a content of indium included in the second transparent conductive layer.

The solar cell may further includes a perovskite solar cell provided between the second transparent conductive layer and the second electrode, wherein the perovskite solar cell may include: a first conductive charge transporting layer formed of a hole transporting layer contacting the second transparent conductive layer; a light absorption layer formed of a perovskite compound provided on the first conductive charge transporting layer; and a second conductive charge transporting layer formed of an electron transporting layer provided on the light absorption layer.

Moreover, the present invention provides a method of manufacturing a solar cell, the method including: a process of forming a first semiconductor layer on one surface of a semiconductor substrate; a process of forming a second semiconductor layer on one surface of the first semiconductor layer; a process of forming a third semiconductor layer on one surface of the second semiconductor layer; a process of forming a first transparent conductive layer on one surface of the third semiconductor layer; and a process of forming a first electrode on one surface of the first transparent conductive layer, wherein the process of forming the third semiconductor layer includes a process of forming a p-type semiconductor material including W, and the process of forming the third semiconductor layer and the process of forming the first transparent conductive layer include a continuous process performed in the same process equipment.

The process of forming the first transparent conductive layer may include a process of forming a transparent oxide film including indium.

The method may further include: a process of forming a fourth semiconductor layer provided on the other surface of the semiconductor substrate; a process of forming a fifth semiconductor layer provided on the other surface of the fourth semiconductor layer; a process of forming a second transparent conductive layer provided on the other surface of the fifth semiconductor layer; and a process of forming a second electrode provided on the other surface of the second transparent conductive layer, wherein the process of forming the fifth semiconductor layer may include a process of forming an n-type semiconductor material including tin (Sn), and the process of forming the fifth semiconductor layer and the process of forming the second transparent conductive layer may include a continuous process performed in the same process equipment.

The process of forming the fifth semiconductor layer may include a process of forming SnO by supplying a material including Sn and a material including oxygen (O) in a chamber, and the process of forming the second transparent conductive layer may include a process of forming a transparent oxide film including indium by supplying the material including Sn, the material including O, and a material including indium in the chamber

The process of forming the fifth semiconductor layer and the process of forming the second transparent conductive layer may comprise forming an SnO layer by supplying a material including Sn and a material including O in a chamber, and additionally doping indium on the SnO layer in the chamber to form the fifth semiconductor layer formed of an indium-undoped SnO layer and the second transparent conductive layer formed of a transparent oxide film including indium based on doping of indium.

The method may further include a process of forming an n-type amorphous silicon layer, between the process of forming the fourth semiconductor layer and the process of forming the fifth semiconductor layer, wherein the process of forming the fourth semiconductor layer and the process of forming the n-type amorphous silicon layer may include a continuous process performed in the same process equipment.

The method may further include a process of forming a perovskite solar cell between the second transparent conductive layer and the second electrode, wherein the process of forming the perovskite solar cell may include: a process of forming a first conductive charge transporting layer formed of a hole transporting layer contacting the second transparent conductive layer; a process of forming a light absorption layer, formed of a perovskite compound, on the first conductive charge transporting layer; and a process of forming a second conductive charge transporting layer, formed of an electron transporting layer, on the light absorption layer.

### [Advantageous Effect]

According to the present invention, the following effects may be realized.

According to an embodiment of the present invention, a p+-type semiconductor layer including W may be additionally formed between a first transparent conductive layer and a second semiconductor layer formed of a p-type semiconductor layer, thereby increasing an open-circuit voltage of a solar cell.

Also, according to an embodiment of the present invention, a third semiconductor layer may include WO₃ and a first transparent conductive layer may include WO₃ doped with indium, and thus, there is an advantage where the third semiconductor layer and the first transparent conductive layer may be formed by a continuous process in the same process equipment.

Also, according to an embodiment of the present invention, because a fifth semiconductor layer formed of an n-type semiconductor layer includes SnO having a large bandgap, an open-circuit voltage of a solar cell may increase, and a second transparent conductive layer formed on the fifth semiconductor layer may include SnO doped with indium, whereby there is an advantage where the fifth semiconductor layer and the second transparent conductive layer may be formed by a continuous process in the same process equipment.

Also, according to an embodiment of the present invention, because a fifth semiconductor layer formed of an n-type semiconductor layer includes SnO having excellent electrical conductivity, a problem where an electrical resistance increases may be prevented even when a thickness of the second transparent conductive layer formed on the fifth semiconductor layer decreases.

### [Description of Drawings]

FIG. 1 is a cross-sectional view of a solar cell according to an embodiment of the present invention.
FIG. 2 is a cross-sectional view of a solar cell according to another embodiment of the present invention.
FIG. 3 is a cross-sectional view of a solar cell according to another embodiment of the present invention.
FIG. 4 is a cross-sectional view of a solar cell according to another embodiment of the present invention.
FIGs. 5A to 5C are cross-sectional views of a process of manufacturing a solar cell according to an embodiment of the present invention.
FIGs. 6A to 6C are cross-sectional views of a process of manufacturing a solar cell according to another embodiment of the present invention.
FIGs. 7A to 7D are cross-sectional views of a process of manufacturing a solar cell according to another embodiment of the present invention.
FIGs. 8A to 8D are cross-sectional views of a process of manufacturing a solar cell according to another embodiment of the present invention.

### [Mode for Invention]

Advantages and features of the present invention, and implementation methods thereof will be clarified through following embodiments described with reference to the accompanying drawings. The present invention may, however, be embodied in different forms and should not be construed as limited to the embodiments set forth herein. Rather, these embodiments are provided so that this invention will be thorough and complete, and will fully convey the scope of the present invention to those skilled in the art. Furthermore, the present invention is only defined by scopes of claims.

A shape, a size, a ratio, an angle, and a number disclosed in the drawings for describing embodiments of the present invention are merely an example, and thus, the present invention is not limited to the illustrated details. Like reference numerals refer to like elements throughout. In the following description, when the detailed description of the relevant known technology is determined to unnecessarily obscure the important point of the present invention, the detailed description will be omitted. In a case where 'comprise', 'have', and 'include' described in the present specification are used, another part may be added unless 'only-' is used. The terms of a singular form may include plural forms unless referred to the contrary.

In construing an element, the element is construed as including an error range although there is no explicit description.

In describing a position relationship, for example, when a position relation between two parts is described as `on~', 'over-', `under~', and 'next-', one or more other parts may be disposed between the two parts unless 'just' or 'direct' is used.

In describing a time relationship, for example, when the temporal order is described as `after~', `subsequent~', 'next-', and 'before-', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various embodiments of the present invention may be partially or overall coupled to or combined with each other, and may be variously inter-operated with each other and driven technically as those skilled in the art can sufficiently understand. The embodiments of the present invention may be carried out independently from each other, or may be carried out together in co-dependent relationship.

Hereinafter, preferable embodiments of the present invention will be described in detail with reference to the accompanying drawings.

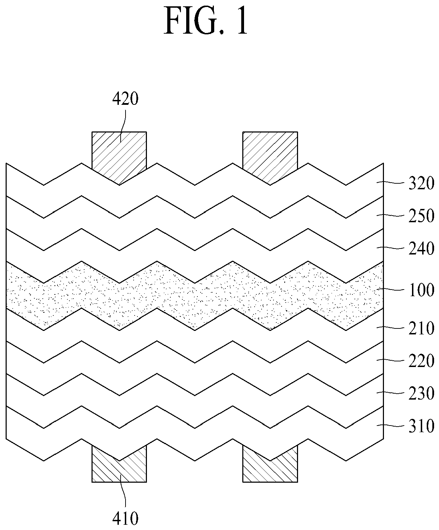

FIG. 1 is a cross-sectional view of a solar cell according to an embodiment of the present invention.

As seen in FIG. 1, the solar cell according to an embodiment of the present invention includes a semiconductor substrate 100, a first semiconductor layer 210, a second semiconductor layer 220, a third semiconductor layer 230, a fourth semiconductor layer 240, a fifth semiconductor layer 250, a first transparent conductive layer 310, a second transparent conductive layer 320, a first electrode 410, and a second electrode 420.

The semiconductor substrate 100 may include an N-type semiconductor wafer. One surface and the other surface (in detail, a bottom surface and a top surface) of the semiconductor substrate 100 may be formed in a concave-convex structure. Therefore, a plurality of layers stacked on the one surface of the semiconductor substrate 100 and a plurality of layers stacked on the other surface of the semiconductor substrate 100 may be stacked in a concave-convex structure corresponding to the concave-convex structure of the semiconductor substrate 100. However, a concave-convex structure may be formed in only one of the one surface and the other surface of the semiconductor substrate 100, or a concave-convex structure may not be formed in the one surface and the other surface of the semiconductor substrate 100.

The first semiconductor layer 210 is formed on the one surface (for example, the bottom surface) of the semiconductor substrate 100. The first semiconductor layer 210 may be formed through a thin film deposition process such as a chemical vapor deposition (CVD) process or an atomic layer deposition (ALD) process and may be formed of an intrinsic semiconductor layer (for example, an intrinsic amorphous silicon layer). However, depending on the case, the first semiconductor layer 210 may be formed of a semiconductor layer doped with a small amount of dopant (for example, a small amount of p-type dopant), and particularly, may be formed of an amorphous silicon layer doped with a small amount of p-type dopant.

The second semiconductor layer 220 is formed on one surface (for example, a bottom surface) of the first semiconductor layer 210. The second semiconductor layer 220 may be formed through a thin film deposition process such as a CVD process or an ALD process and may be formed of a semiconductor layer doped with a specific dopant. In detail, the second semiconductor layer 220 may be formed of a p-type semiconductor layer doped with a p-type dopant having a polarity which differs from that of the semiconductor substrate 100, and particularly, may be formed of a p-type amorphous silicon layer.

The third semiconductor layer 230 is formed on one surface (for example, a bottom surface) of the second semiconductor layer 220. The third semiconductor layer 230 is formed of a p+-type semiconductor layer formed through a thin film deposition process. In detail, the third semiconductor layer 230 may include a p-type semiconductor material (in detail, WO₃) including tungsten (W), which is formed by using an ALD process. A bandgap of WO₃ is less than a bandgap of p-type amorphous silicon constituting the second semiconductor layer 220. Also, a work function of WO₃ is greater than a work function of p-type amorphous silicon constituting the second semiconductor layer 220. Also, a valence band maximum energy level of WO₃ is lower than a valence band maximum energy level of the p-type amorphous silicon layer. Accordingly, in a case where WO₃ is used as a material of the third semiconductor layer 230, there is an advantage where an open-circuit voltage (Voc) of a solar cell may increase.

The third semiconductor layer 230 may additionally include a p-type dopant such as titanium (Ti) or hydrogen (H), and thus, an interface resistance and a bulk resistance of the third semiconductor layer 230 may be reduced and the mobility of an electric charge may be enhanced, thereby enhancing the efficiency of a solar cell.

The fourth semiconductor layer 240 is formed on the other surface (for example, the top surface) of the semiconductor substrate 100. The fourth semiconductor layer 240 may be formed through a thin film deposition process and may be formed of an intrinsic semiconductor layer (for example, an intrinsic amorphous silicon layer). However, depending on the case, the fourth semiconductor layer 240 may be formed of an amorphous silicon layer doped with a small amount of dopant (for example, a small amount of n-type dopant). In detail, a polarity of a dopant doped on the fourth semiconductor layer 240 is opposite to that of a dopant doped on the first semiconductor layer 210.

The fifth semiconductor layer 250 is formed on the other surface (for example, a top surface) of the fourth semiconductor layer 240. The fifth semiconductor layer 250 may be formed through a thin film deposition process and may be formed of a semiconductor layer doped with a specific dopant. In this case, a polarity of a dopant doped on the fifth semiconductor layer 250 is opposite to that of a dopant doped on the second semiconductor layer 220.

According to an embodiment of the present invention, the fifth semiconductor layer 250 may be formed of an n-type amorphous semiconductor layer formed through a thin film deposition process such as a CVD process or an ALD process.

Moreover, according to another embodiment of the present invention, the fifth semiconductor layer 250 may include an n-type semiconductor material including tin (Sn) formed by using an ALD, and in detail, may include SnO. Because SnO is an n-type semiconductor material and is good in electrical conductivity, in a case where the fifth semiconductor layer 250 includes SnO, there is an advantage where a thickness of the second transparent conductive layer 320 formed on the fifth semiconductor layer 250 may be reduced.

A material of the fifth semiconductor layer 250 may use a material such as aluminum (Al), silver (Ag), and LiF, but because a bandgap of SnO is greater than that of Al, Ag, and LiF, in a case where the fifth semiconductor layer 250 includes SnO, there is an advantage where an open-circuit voltage (Voc) of a solar cell may increase. Furthermore, because an energy bandgap of Cs₂CO₃ is greater than that of SnO, Cs₂CO₃ may be used as the fifth semiconductor layer 250, but when the fifth semiconductor layer 250 is formed of SnO, there is an advantage where the second transparent conductive layer 320 may be formed of indium tin oxide (ITO) by a simple process of adding indium in the same process equipment.

The fifth semiconductor layer 250 may additionally include an n-type dopant such as indium (In), fluorine (F), or zinc (Zn), and thus, an interface resistance and a bulk resistance of the fifth semiconductor layer 250 may be reduced and the mobility of an electric charge may be enhanced, thereby enhancing the efficiency of a solar cell.

It may be preferable that a thickness of the fifth semiconductor layer 250 is within a range of 10 Å to 100 Å. For example, when a thickness of the fifth semiconductor layer 250 is less than 10 Å, the movement of an electric charge may not be smoothly performed in the fifth semiconductor layer 250, and when a thickness of the fifth semiconductor layer 250 is greater than 100 Å, a transmittance of the fifth semiconductor layer 250 may decrease.

The first transparent conductive layer 310 is formed on one surface (for example, a bottom surface) of the third semiconductor layer 230. The first transparent conductive layer 310 may be formed through a thin film deposition process such as a CVD process or an ALD process. Particularly, the first transparent conductive layer 310 may include a transparent oxide film (in detail, WO₃ doped with indium) including indium, and in this case, the third semiconductor layer 230 and the first transparent conductive layer 310 may be formed by a continuous process in the same process equipment.

The first transparent conductive layer 310 may be formed on a surface opposite to a sunlight incident surface, and thus, a thickness of the first transparent conductive layer 310 may be thickly formed more based on electrical conductivity than a light transmittance. Accordingly, a thickness of the first transparent conductive layer 310 may be formed to be thicker than that of the second transparent conductive layer 320. Also, in a case where the first transparent conductive layer 310 includes WO₃ doped with indium, when a content of indium increases, a transmittance may be reduced, but electrical conductivity may be enhanced. As described above, the first transparent conductive layer 310 may be formed more based on electrical conductivity than a transmittance, and thus, it is preferable that electrical conductivity is enhanced by increasing a content of indium included in the first transparent conductive layer 310. Accordingly, a content of indium included in the first transparent conductive layer 310 may be higher than a content of indium included in the below-described second transparent conductive layer 320.

The second transparent conductive layer 320 is formed on the other surface (for example, a top surface) of the fifth semiconductor layer 250.

The second transparent conductive layer 320 is formed through a thin film deposition process such as a CVD process or an ALD process.

As described above, because an electrical conductivity of the fifth semiconductor layer 250 is excellent, a thickness of the second transparent conductive layer 320 may be formed to be thin, and in detail, a thickness of the second transparent conductive layer 320 may be formed within a range of 100 Å to 500 Å. For example, when a thickness of the second transparent conductive layer 320 is less than 100 Å, a resistance of the second transparent conductive layer 320 may increase, and when a thickness of the second transparent conductive layer 320 is greater than 500 Å, a transmittance of the second transparent conductive layer 320 may decrease.

The second transparent conductive layer 320 may include a transparent oxide film including indium (for example, ITO), and thus, as described above, the fifth semiconductor layer 250 and the second transparent conductive layer 320 may be formed by a continuous process in the same process equipment.

In a case where the second transparent conductive layer 320 includes a transparent oxide film including indium, it may be preferable that a concentration of indium in the transparent oxide film is within a range of 1 at% to 5 at%. For example, when a concentration of indium in the transparent oxide film is less than 1 at%, an electrical conductivity of the second transparent conductive layer 320 may be reduced, and when a concentration of indium in the transparent oxide film is higher than 5 at%, a transmittance of the second transparent conductive layer 320 may decrease.

Moreover, the concentration of indium may not be constant in the second transparent conductive layer 320. In detail, the concentration of indium in a top surface of the second transparent conductive layer 320 may be greater than the concentration of indium in a bottom surface of the second transparent conductive layer 320, and particularly, the concentration of indium may increase gradually toward the top surface of the second transparent conductive layer 320 from the bottom surface of the second transparent conductive layer 320.

The first electrode 410 is formed on one surface (for example, a bottom surface) of the first transparent conductive layer 310.

The first electrode 410 may be formed on a surface opposite to an incident surface on which sunlight is incident, and thus, may be formed on a whole bottom surface of the first transparent conductive layer 310. However, the first electrode 410 may be patterned and formed in a specific shape, and thus, may be configured so that reflected light of sunlight is incident on an inner portion of a solar cell through the first transparent conductive layer 310. The first electrode 410 may include various metal materials known to those skilled in the art and may be formed by various pattern formation processes such as a screen printing process known to those skilled in the art.

The second electrode 420 is formed on the other surface (for example, a top surface) of the second transparent conductive layer 320.

The second electrode 420 is formed on an incident surface on which sunlight is incident, and thus, in order to prevent the amount of incident sunlight from being reduced by the second electrode 420, the second electrode 420 is patterned and formed in a specific shape. The second electrode 420 may include various metal materials known to those skilled in the art and may be formed by various pattern formation processes such as a screen printing process known to those skilled in the art.

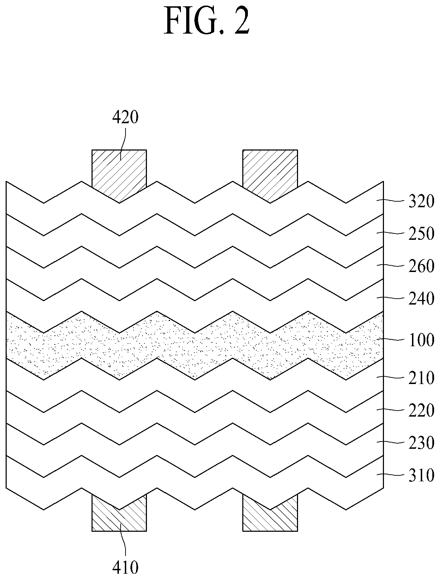

FIG. 2 is a cross-sectional view of a solar cell according to another embodiment of the present invention.

As seen in FIG. 2, the solar cell according to another embodiment of the present invention includes a semiconductor substrate 100, a first semiconductor layer 210, a second semiconductor layer 220, a third semiconductor layer 230, a fourth semiconductor layer 240, a fifth semiconductor layer 250, a sixth semiconductor layer 260, a first transparent conductive layer 310, a second transparent conductive layer 320, a first electrode 410, and a second electrode 420.

Except for that the sixth semiconductor layer 260 is added, the solar cell according to another embodiment of the present invention illustrated in FIG. 2 is the same as the solar cell according to FIG. 1 described above. Accordingly, like reference numerals refer to like elements, and only different elements willy be described below.

As seen in FIG. 2, according to another embodiment of the present invention, the sixth semiconductor layer 260 is additionally formed between the fourth semiconductor layer 240 and the fifth semiconductor layer 250. That is, the sixth semiconductor layer 260 is formed between a top surface of the fourth semiconductor layer 240 and a bottom surface of the fifth semiconductor layer 250.

The sixth semiconductor layer 260 may be formed through a thin film deposition process and may be formed of a semiconductor layer doped with a dopant (for example, an n-type dopant) having the same polarity as that of the fifth semiconductor layer 250. In this case, it is preferable that the sixth semiconductor layer 260 is formed of a material having a bandgap which is less than that of the fifth semiconductor layer 250 including SnO, and in detail, the sixth semiconductor layer 260 may be formed of an n-type amorphous silicon layer. A work function of the fifth semiconductor layer 250 including SnO may be less than a work function of the sixth semiconductor layer 260 including the n-type amorphous silicon layer. Also, it is preferable that a conduction band minimum energy level of the fifth semiconductor layer 250 including SnO is higher than a conduction band minimum energy level of the sixth semiconductor layer 260 including the n-type amorphous silicon layer. In this case, the fifth semiconductor layer 250 including SnO configures an n+-type semiconductor layer. When the sixth semiconductor layer 260 includes the n-type amorphous silicon layer, an interface characteristic between the fourth semiconductor layer 240 and the fifth semiconductor layer 250 may be enhanced.

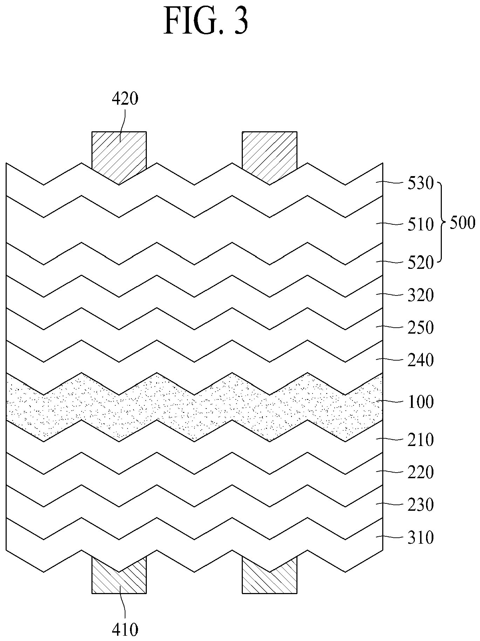

FIG. 3 is a cross-sectional view of a solar cell according to another embodiment of the present invention.

As seen in FIG. 3, the solar cell according to another embodiment of the present invention includes a semiconductor substrate 100, a first semiconductor layer 210, a second semiconductor layer 220, a third semiconductor layer 230, a fourth semiconductor layer 240, a fifth semiconductor layer 250, a first transparent conductive layer 310, a second transparent conductive layer 320, a first electrode 410, a second electrode 420, and a perovskite solar cell 500.

Except for that the perovskite solar cell 500 is added, the solar cell according to another embodiment of the present invention illustrated in FIG. 3 is the same as the solar cell according to FIG. 1 described above. Accordingly, like reference numerals refer to like elements, and only different elements willy be described below.

As seen in FIG. 3, according to another embodiment of the present invention, the perovskite solar cell 500 is additionally formed between the second transparent conductive layer 320 and the second electrode 420 in a structure of FIG. 1 described above.

Therefore, the solar cell according to another embodiment of the present invention may be a solar cell having a tandem structure including a bulk-type solar cell, which includes the semiconductor substrate 100, the first semiconductor layer 210, the second semiconductor layer 220, the third semiconductor layer 230, the fourth semiconductor layer 240, the fifth semiconductor layer 250, the first transparent conductive layer 310, and the second transparent conductive layer 320, and the perovskite solar cell 500 formed on the bulk-type sola cell.

In this case, the second transparent conductive layer 320 may function as a buffer layer between the bulk-type solar cell and the perovskite solar cell 500, and thus, a separate buffer layer is not needed.

The perovskite solar cell 500 may include conductive charge transporting layers 520 and 530 and a light absorption layer 510.

The perovskite solar cell 500 may include one or more conductive charge transporting layers 520 and 530. For example, the perovskite solar cell 500 may include a first conductive charge transporting layer 520 which is provided on the second transparent conductive layer 320 and contacting the second transparent conductive layer 320, a light absorption layer 510 which is provided on the first conductive charge transporting layer 520, and a second conductive charge transporting layer 530 which is provided on the light absorption layer 510. However, the present invention is not limited thereto, and the conductive charge transporting layers 520 and 530 may be disposed on only one surface of both surfaces of the light absorption layer 510.

The first conductive charge transporting layer 520 may be configured to have a polarity (for example, a p-type polarity) which differs from that of the fifth semiconductor layer 250, and the second conductive charge transporting layer 530 may be configured to have a polarity (for example, an n-type polarity) which differs from that of the first conductive charge transporting layer 520. Accordingly, the first conductive charge transporting layer 520 may be formed of a hole transporting layer (HTL), and the second conductive charge transporting layer 530 may be formed of an electron transporting layer (ETL).

The hole transporting layer may include various p-type organic materials such as Spiro-MeO-TAD, Spiro-TTB, polyaniline, polyphenol, poly(3,4-ethylenedioxythiophene)-poly(styrenesulfonate) (PEDOT-PSS), poly[bis(4-phenyl)(2,4,6-trimethylphenyl)amine] (PTAA), and poly(3-hexylthiophene-2,5-diyl) (P3HT) known to those skilled in the art, or may include a compound including various P-type organic or inorganic materials and various P-type metal oxides such as Ni oxide, Mo oxide, V oxide, W oxide, or Cu oxide known to those skilled in the art.

The electron transporting layer may include a compound including various N-type organic or inorganic materials and an N-type organic material, such as bathocuproine (BCP), C60, or phenyl-C61-butyric acid methyl ester (PCBM), or various N-type metal oxides such as ZnO, c-TiO₂/mp-TiO₂, SnOz, or IZO known to those skilled in the art.

The light absorption layer 510 includes a perovskite compound known to those skilled in the art.

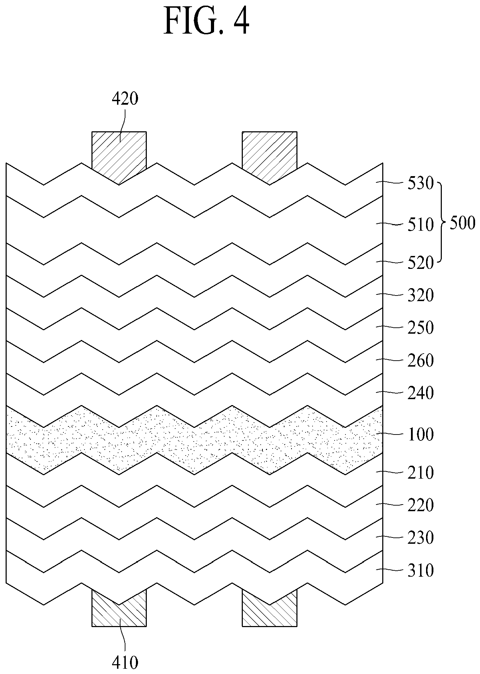

FIG. 4 is a cross-sectional view of a solar cell according to another embodiment of the present invention.

As seen in FIG. 4, the solar cell according to another embodiment of the present invention includes a semiconductor substrate 100, a first semiconductor layer 210, a second semiconductor layer 220, a third semiconductor layer 230, a fourth semiconductor layer 240, a fifth semiconductor layer 250, a sixth semiconductor layer 260, a first transparent conductive layer 310, a second transparent conductive layer 320, a first electrode 410, a second electrode 420, and a perovskite solar cell 500.

Except for that the perovskite solar cell 500 is added, the solar cell according to another embodiment of the present invention illustrated in FIG. 4 is the same as the solar cell according to FIG. 2 described above. Accordingly, like reference numerals refer to like elements, and only different elements willy be described below.

As seen in FIG. 4, according to another embodiment of the present invention, the perovskite solar cell 500 is additionally formed between the second transparent conductive layer 320 and the second electrode 420 in a structure of FIG. 2 described above.

Therefore, the solar cell according to another embodiment of the present invention may be a solar cell having a tandem structure including a bulk-type solar cell, which includes the semiconductor substrate 100, the first semiconductor layer 210, the second semiconductor layer 220, the third semiconductor layer 230, the fourth semiconductor layer 240, the fifth semiconductor layer 250, the sixth semiconductor layer 260, the first transparent conductive layer 310, and the second transparent conductive layer 320, and the perovskite solar cell 500 formed on the bulk-type sola cell.

In this case, the second transparent conductive layer 320 may function as a buffer layer between the bulk-type solar cell and the perovskite solar cell 500, and thus, a separate buffer layer is not needed.

The perovskite solar cell 500 may include conductive charge transporting layers 520 and 530 and a light absorption layer 510 as in FIG. 3 described above, and its repeated description is omitted.

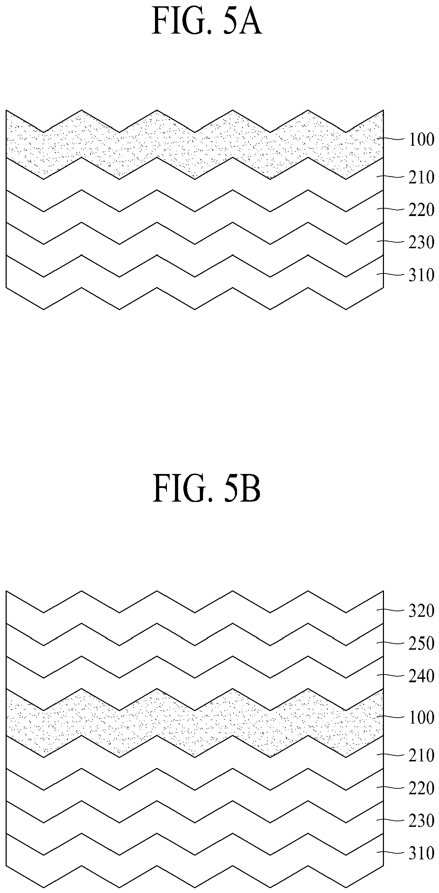

FIGs. 5A to 5C are cross-sectional views of a process of manufacturing a solar cell according to an embodiment of the present invention and relate to a process of manufacturing the solar cell according to FIG. 1 described above. Hereinafter, a repeated description of the same element such as a material is omitted.

First, as seen in FIG. 5A, a first semiconductor layer 210 is formed on one surface (for example, a bottom surface) of a semiconductor substrate 100, a second semiconductor layer 220 is formed on one surface (for example, a bottom surface) of the first semiconductor layer 210, a third semiconductor layer 230 is formed on one surface (for example, a bottom surface) of the second semiconductor layer 220, and a first transparent conductive layer 310 is formed on one surface (for example, a bottom surface) of the third semiconductor layer 230.

The first semiconductor layer 210 may be formed of an intrinsic semiconductor layer (for example, an intrinsic amorphous silicon layer) or a semiconductor layer doped with a small amount of p-type dopant (particularly, an amorphous silicon layer doped with a small amount of p-type dopant) through a thin film deposition process such as a chemical vapor deposition (CVD) process or an atomic layer deposition (ALD) process.

The second semiconductor layer 220 may be formed of a p-type amorphous silicon layer through a thin film deposition process such as a chemical vapor deposition (CVD) process or an atomic layer deposition (ALD) process.

In this case, the first semiconductor layer 210 and the second semiconductor layer 220 may be formed by a continuous process in the same process equipment. In detail, the first semiconductor layer 210 including an intrinsic amorphous silicon layer may be formed by supplying a source material of silicon (Si) in a chamber through a thin film deposition process such as a chemical vapor deposition (CVD) process or an atomic layer deposition (ALD) process, and subsequently, the second semiconductor layer 220 including a p-type amorphous silicon layer may be formed by additionally supplying a p-type dopant material together with the source material of Si through a chemical vapor deposition (CVD) process or an atomic layer deposition (ALD) process.

The third semiconductor layer 230 may be formed of a p+-type semiconductor layer including WO₃ through a thin film deposition process (particularly, an atomic layer deposition process) such as a chemical vapor deposition (CVD) process or an atomic layer deposition (ALD) process.

The first transparent conductive layer 310 may be formed of WO₃ doped with indium through a thin film deposition process such as a chemical vapor deposition (CVD) process or an atomic layer deposition (ALD) process.

In this case, the third semiconductor layer 230 and the first transparent conductive layer 310 may be formed by a continuous process in the same process equipment. For example, the third semiconductor layer 230 including WO₃ may be formed by supplying a material including W and a material including oxygen (O) in a chamber through a chemical vapor deposition (CVD) process or an atomic layer deposition (ALD) process, and subsequently, the first transparent conductive layer 310 including WO₃ doped with indium may be formed by additionally supplying a material including indium together with the material including W and the material including O through a chemical vapor deposition (CVD) process or an atomic layer deposition (ALD) process.

Subsequently, as seen in FIG. 5B, a fourth semiconductor layer 240 is formed on the other surface (for example, a top surface) of the semiconductor substrate 100, a fifth semiconductor layer 250 is formed on the other surface (for example, a top surface) of the fourth semiconductor layer 240, and a second transparent conductive layer 320 is formed on the other surface (for example, a top surface) of the fifth semiconductor layer 250.

The fourth semiconductor layer 240 may be formed of an intrinsic semiconductor layer (for example, an intrinsic amorphous silicon layer) or a semiconductor layer doped with a small amount of n-type dopant (particularly, an amorphous silicon layer doped with a small amount of n-type dopant) through a thin film deposition process such as a chemical vapor deposition (CVD) process or an atomic layer deposition (ALD) process.

According to an embodiment of the present invention, the fifth semiconductor layer 250 may be formed of an n-type amorphous silicon layer through a thin film deposition process such as a chemical vapor deposition (CVD) process or an atomic layer deposition (ALD) process.

In this case, the fourth semiconductor layer 240 and the fifth semiconductor layer 250 may be formed by a continuous process in the same process equipment. In detail, the fourth semiconductor layer 240 including an intrinsic amorphous silicon layer may be formed by supplying a source material of Si in a chamber through a thin film deposition process such as a chemical vapor deposition (CVD) process or an atomic layer deposition (ALD) process, and subsequently, the fifth semiconductor layer 250 including an n-type amorphous silicon layer may be formed by additionally supplying an n-type dopant material together with the source material of Si through a chemical vapor deposition (CVD) process or an atomic layer deposition (ALD) process.

According to another embodiment of the present invention, the fifth semiconductor layer 250 may be formed of SnO through an atomic layer deposition (ALD) process.

The second transparent conductive layer 320 may be formed of a transparent oxide film including indium by using a chemical vapor deposition (CVD) process or an atomic layer deposition (ALD) process.

In this case, the fifth semiconductor layer 250 and the second transparent conductive layer 320 may be formed by a continuous process in the same process equipment. For example, the fifth semiconductor layer 250 including SnO may be formed by supplying a material including Sn and a material including O in a chamber through a chemical vapor deposition (CVD) process or an atomic layer deposition (ALD) process, and subsequently, the second transparent conductive layer 320 including a transparent oxide film including indium may be formed by additionally supplying a material including indium together with the material including Sn and the material including O through a chemical vapor deposition (CVD) process or an atomic layer deposition (ALD) process.

Depending on the case, an SnO layer may be formed by additionally supplying a material including Sn and a material including O in the chamber through a chemical vapor deposition (CVD) process or an atomic layer deposition (ALD) process, and subsequently, by additionally implanting indium into the SnO layer, the fifth semiconductor layer 250 including an indium-undoped SnO layer and the second transparent conductive layer 320 including a transparent oxide film including indium based on doping of indium may be formed.

Furthermore, a special order is not set between a process of FIG. 5A and a process of FIG. 5B. That is, the process of FIG. 5B may be first performed, and then, the process of FIG. 5A may be performed.

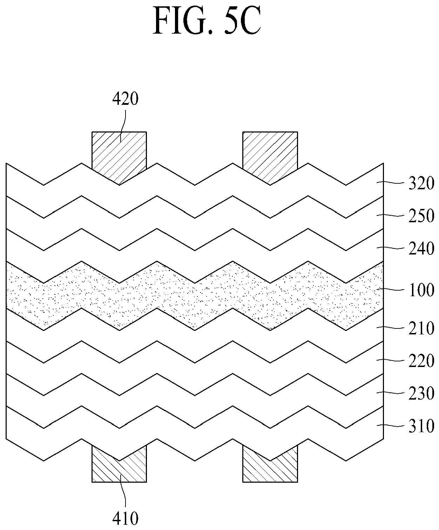

Subsequently, as seen in FIG. 5C, a first electrode 410 is formed on one surface (for example, a bottom surface) of the first transparent conductive layer 310, and a second electrode 420 is formed on the other surface (for example, a top surface) of the second transparent conductive layer 320.

A special order is not set between a process of forming the first electrode 410 and a process of forming the second electrode 420.

The first electrode 410 and the second electrode 420 may be formed through various pattern formation processes such as a screen printing process known to those skilled in the art.

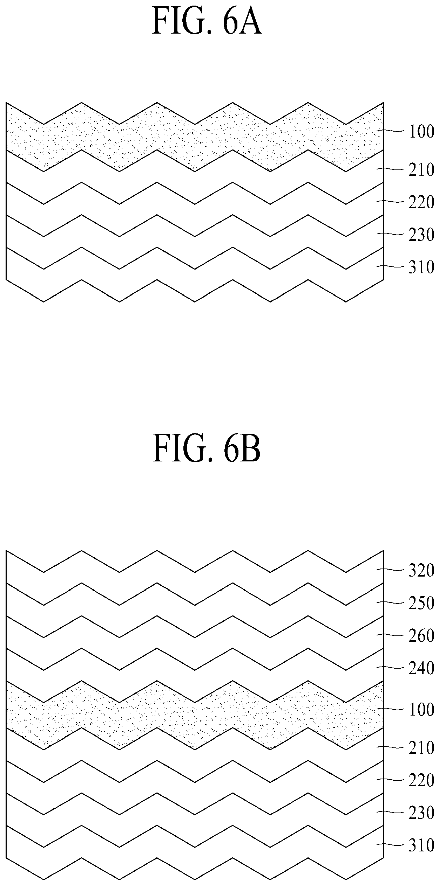

FIGs. 6A to 6C are cross-sectional views of a process of manufacturing a solar cell according to another embodiment of the present invention and relate to a process of manufacturing the solar cell according to FIG. 2 described above. Hereinafter, a repeated description of the same element such as a material is omitted.

First, as seen in FIG. 6A, a first semiconductor layer 210 is formed on one surface (for example, a bottom surface) of a semiconductor substrate 100, a second semiconductor layer 220 is formed on one surface (for example, a bottom surface) of the first semiconductor layer 210, a third semiconductor layer 230 is formed on one surface (for example, a bottom surface) of the second semiconductor layer 220, and a first transparent conductive layer 310 is formed on one surface (for example, a bottom surface) of the third semiconductor layer 230.

The first semiconductor layer 210 may be formed of an intrinsic semiconductor layer (for example, an intrinsic amorphous silicon layer) or a semiconductor layer doped with a small amount of p-type dopant (particularly, an amorphous silicon layer doped with a small amount of p-type dopant) through a thin film deposition process such as a chemical vapor deposition (CVD) process or an atomic layer deposition (ALD) process.

The second semiconductor layer 220 may be formed of a p-type amorphous silicon layer through a thin film deposition process such as a chemical vapor deposition (CVD) process or an atomic layer deposition (ALD) process.

In this case, the first semiconductor layer 210 and the second semiconductor layer 220 may be formed by a continuous process in the same process equipment. In detail, the first semiconductor layer 210 including an intrinsic amorphous silicon layer may be formed by supplying a source material of Si in a chamber through a thin film deposition process such as a chemical vapor deposition (CVD) process or an atomic layer deposition (ALD) process, and subsequently, the second semiconductor layer 220 including a p-type amorphous silicon layer may be formed by additionally supplying a p-type dopant material together with the source material of Si through a chemical vapor deposition (CVD) process or an atomic layer deposition (ALD) process.

The third semiconductor layer 230 may be formed of a p+-type semiconductor layer including WO₃ through a thin film deposition process (particularly, an atomic layer deposition process) such as a chemical vapor deposition (CVD) process or an atomic layer deposition (ALD) process.

The first transparent conductive layer 310 may be formed of WO₃ doped with indium through a thin film deposition process such as a chemical vapor deposition (CVD) process or an atomic layer deposition (ALD) process.

In this case, the third semiconductor layer 230 and the first transparent conductive layer 310 may be formed by a continuous process in the same process equipment. For example, the third semiconductor layer 230 including WO₃ may be formed by supplying a material including W and a material including O in a chamber through a chemical vapor deposition (CVD) process or an atomic layer deposition (ALD) process, and subsequently, the first transparent conductive layer 310 including WO₃ doped with indium may be formed by additionally supplying a material including indium together with the material including W and the material including O through a chemical vapor deposition (CVD) process or an atomic layer deposition (ALD) process.

Subsequently, as seen in FIG. 6B, a fourth semiconductor layer 240 is formed on the other surface (for example, a top surface) of the semiconductor substrate 100, a sixth semiconductor layer 260 is formed on the other surface (for example, a top surface) of the fourth semiconductor layer 240, a fifth semiconductor layer 250 is formed on the other surface (for example, a top surface) of the sixth semiconductor layer 260, and a second transparent conductive layer 320 is formed on the other surface (for example, a top surface) of the fifth semiconductor layer 250.

The fourth semiconductor layer 240 may be formed of an intrinsic semiconductor layer (for example, an intrinsic amorphous silicon layer) or a semiconductor layer doped with a small amount of n-type dopant (particularly, an amorphous silicon layer doped with a small amount of n-type dopant) through a thin film deposition process such as a chemical vapor deposition (CVD) process or an atomic layer deposition (ALD) process.

The sixth semiconductor layer 260 may be formed of an n-type amorphous silicon layer through a thin film deposition process such as a chemical vapor deposition (CVD) process or an atomic layer deposition (ALD) process.

In this case, the fourth semiconductor layer 240 and the sixth semiconductor layer 260 may be formed by a continuous process in the same process equipment. In detail, the fourth semiconductor layer 240 including an intrinsic amorphous silicon layer may be formed by supplying a source material of Si in a chamber through a thin film deposition process such as a chemical vapor deposition (CVD) process or an atomic layer deposition (ALD) process, and subsequently, the sixth semiconductor layer 260 including an n-type amorphous silicon layer may be formed by additionally supplying an n-type dopant material together with the source material of Si through a chemical vapor deposition (CVD) process or an atomic layer deposition (ALD) process.

The fifth semiconductor layer 250 may be formed of SnO through an atomic layer deposition (ALD) process, and the second transparent conductive layer 320 may be formed of a transparent oxide film including indium by using a chemical vapor deposition (CVD) process or an atomic layer deposition (ALD) process.

In this case, the fifth semiconductor layer 250 and the second transparent conductive layer 320 may be formed by a continuous process in the same process equipment. For example, the fifth semiconductor layer 250 including SnO may be formed by supplying a material including Sn and a material including O in a chamber through a chemical vapor deposition (CVD) process or an atomic layer deposition (ALD) process, and subsequently, the second transparent conductive layer 320 including a transparent oxide film including indium may be formed by additionally supplying a material including indium together with the material including Sn and the material including O through a chemical vapor deposition (CVD) process or an atomic layer deposition (ALD) process.

Depending on the case, an SnO layer may be formed by supplying a material including Sn and a material including O in the chamber through a chemical vapor deposition (CVD) process or an atomic layer deposition (ALD) process, and subsequently, by additionally implanting indium thereinto, the fifth semiconductor layer 250 including an indium-undoped SnO layer and the second transparent conductive layer 320 including a transparent oxide film including indium based on doping of indium may be formed.

Furthermore, a special order is not set between a process of FIG. 6A and a process of FIG. 6B. That is, the process of FIG. 6B may be first performed, and then, the process of FIG. 6A may be performed.

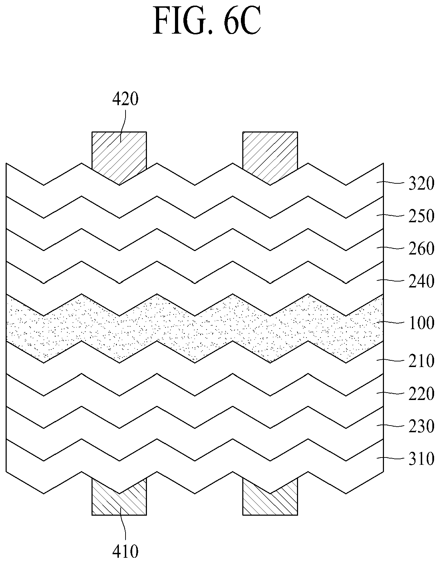

Subsequently, as seen in FIG. 6C, a first electrode 410 is formed on one surface (for example, a bottom surface) of the first transparent conductive layer 310, and a second electrode 420 is formed on the other surface (for example, a top surface) of the second transparent conductive layer 320.

A special order is not set between a process of forming the first electrode 410 and a process of forming the second electrode 420.

The first electrode 410 and the second electrode 420 may be formed through various pattern formation processes such as a screen printing process known to those skilled in the art.

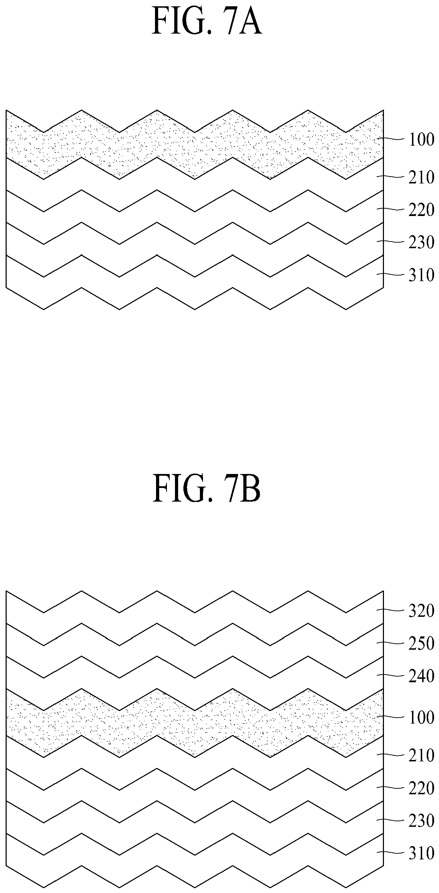

FIGs. 7A to 7D are cross-sectional views of a process of manufacturing a solar cell according to another embodiment of the present invention and relate to a process of manufacturing the solar cell according to FIG. 3 described above.

First, as seen in FIG. 7A, a first semiconductor layer 210 is formed on one surface (for example, a bottom surface) of a semiconductor substrate 100, a second semiconductor layer 220 is formed on one surface (for example, a bottom surface) of the first semiconductor layer 210, a third semiconductor layer 230 is formed on one surface (for example, a bottom surface) of the second semiconductor layer 220, and a first transparent conductive layer 310 is formed on one surface (for example, a bottom surface) of the third semiconductor layer 230.

A process of FIG. 7A is the same as a process of FIG. 5A described above, and thus, a repeated description thereof is omitted.

Subsequently, as seen in FIG. 7B, a fourth semiconductor layer 240 is formed on the other surface (for example, a top surface) of the semiconductor substrate 100, a fifth semiconductor layer 250 is formed on the other surface (for example, a top surface) of the fourth semiconductor layer 240, and a second transparent conductive layer 320 is formed on the other surface (for example, a top surface) of the fifth semiconductor layer 250.

A process of FIG. 7B is the same as a process of FIG. 5B described above, and thus, a repeated description thereof is omitted.

Furthermore, a special order is not set between a process of FIG. 7A and a process of FIG. 7B. That is, the process of FIG. 7B may be first performed, and then, the process of FIG. 7A may be performed.

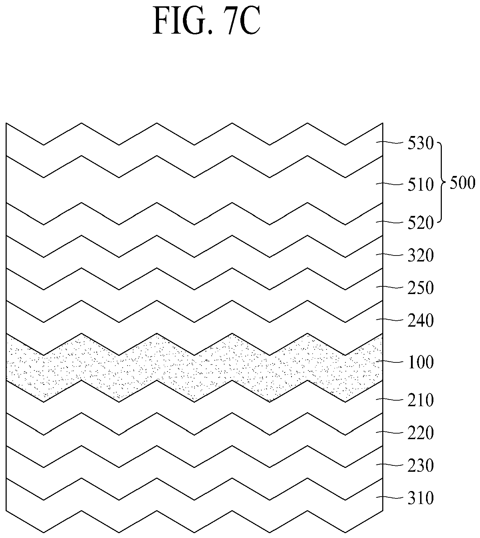

Subsequently, as seen in FIG. 7C, a perovskite solar cell 500 is formed on the other surface (for example, a top surface) of the second transparent conductive layer 320.

A process of forming the perovskite solar cell 500 may include a process of forming a first conductive charge transporting layer 520 on the top surface of the second transparent conductive layer 320, a process of forming a light absorption layer 510 on the top surface of the first conductive charge transporting layer 520, and a process of forming a second conductive charge transporting layer 530 on a top surface of the light absorption layer 510.

A process of forming the first conductive charge transporting layer 520 may include a process of forming a hole transporting layer (HTL) including an organic material through a thin film deposition process such as an evaporation process, and a process of forming the second conductive charge transporting layer 530 may include a process of forming an electron transporting layer (ETL) including an organic material through a thin film deposition process such as an evaporation process.

A process of forming the light absorption layer 510 may include a process of forming a perovskite compound through a solution process or a thin film deposition process such as a chemical vapor deposition (CVD) process.

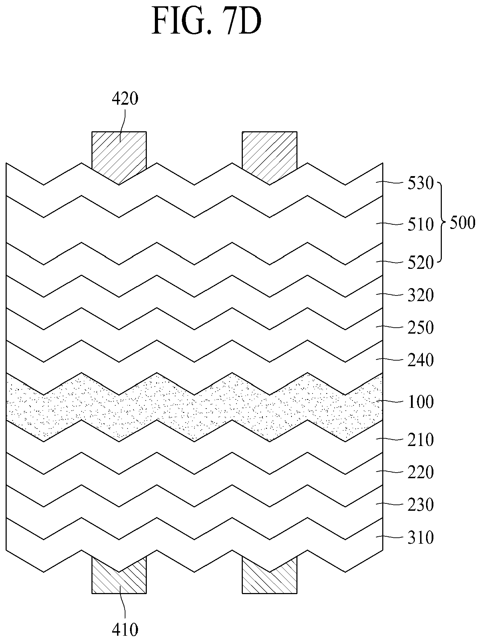

Subsequently, as seen in FIG. 7D, a second electrode 420 is formed on the other surface (for example, a top surface) of the perovskite solar cell 500, and a first electrode 410 is formed on one surface (for example, a bottom surface) of the first transparent conductive layer 310.

A special order is not set between a process of forming the first electrode 410 and a process of forming the second electrode 420. The first electrode 410 and the second electrode 420 may be formed through various pattern formation processes such as a screen printing process known to those skilled in the art.

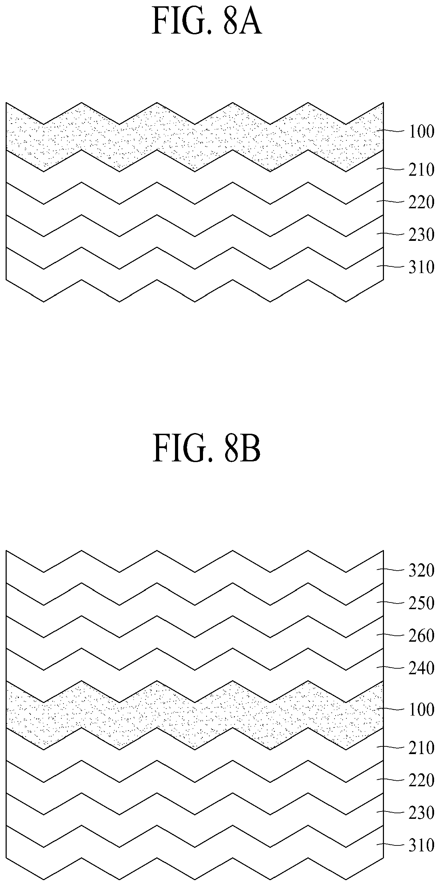

FIGs. 8A to 8D are cross-sectional views of a process of manufacturing a solar cell according to another embodiment of the present invention and relate to a process of manufacturing the solar cell according to FIG. 4 described above.

First, as seen in FIG. 8A, a first semiconductor layer 210 is formed on one surface (for example, a bottom surface) of a semiconductor substrate 100, a second semiconductor layer 220 is formed on one surface (for example, a bottom surface) of the first semiconductor layer 210, a third semiconductor layer 230 is formed on one surface (for example, a bottom surface) of the second semiconductor layer 220, and a first transparent conductive layer 310 is formed on one surface (for example, a bottom surface) of the third semiconductor layer 230.

A process of FIG. 8A is the same as a process of FIG. 6A described above, and thus, a repeated description thereof is omitted.

Subsequently, as seen in FIG. 8B, a fourth semiconductor layer 240 is formed on the other surface (for example, a top surface) of the semiconductor substrate 100, a sixth semiconductor layer 260 is formed on the other surface (for example, a top surface) of the fourth semiconductor layer 240, a fifth semiconductor layer 250 is formed on the other surface (for example, a top surface) of the sixth semiconductor layer 260, and a second transparent conductive layer 320 is formed on the other surface (for example, a top surface) of the fifth semiconductor layer 250.

A process of FIG. 8B is the same as a process of FIG. 6B described above, and thus, a repeated description thereof is omitted.

Furthermore, a special order is not set between a process of FIG. 8A and a process of FIG. 8B. That is, the process of FIG. 8B may be first performed, and then, the process of FIG. 8A may be performed.

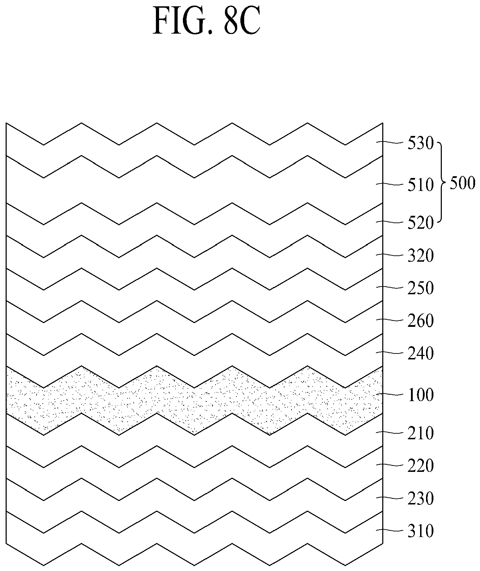

Subsequently, as seen in FIG. 8C, a perovskite solar cell 500 is formed on the other surface (for example, a top surface) of the second transparent conductive layer 320.

A process of forming the perovskite solar cell 500 may include a process of forming a first conductive charge transporting layer 520 on the top surface of the second transparent conductive layer 320, a process of forming a light absorption layer 510 on the top surface of the first conductive charge transporting layer 520, and a process of forming a second conductive charge transporting layer 530 on a top surface of the light absorption layer 510.

A process of forming the first conductive charge transporting layer 520 may include a process of forming a hole transporting layer (HTL) including an organic material through a thin film deposition process such as an evaporation process, and a process of forming the second conductive charge transporting layer 530 may include a process of forming an electron transporting layer (ETL) including an organic material through a thin film deposition process such as an evaporation process.

A process of forming the light absorption layer 510 may include a process of forming a perovskite compound through a solution process or a thin film deposition process such as a chemical vapor deposition (CVD) process.

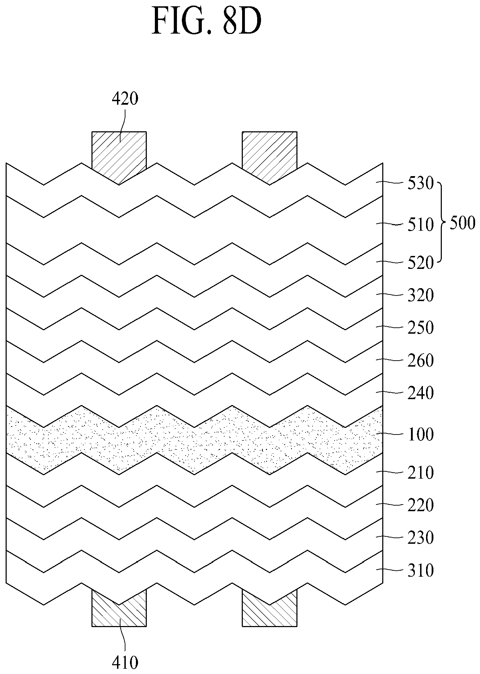

Subsequently, as seen in FIG. 8D, a second electrode 420 is formed on the other surface (for example, a top surface) of the perovskite solar cell 500, and a first electrode 410 is formed on one surface (for example, a bottom surface) of the first transparent conductive layer 310.

A special order is not set between a process of forming the first electrode 410 and a process of forming the second electrode 420. The first electrode 410 and the second electrode 420 may be formed through various pattern formation processes such as a screen printing process known to those skilled in the art.

Hereinabove, the embodiments of the present invention have been described in more detail with reference to the accompanying drawings, but the present invention is not limited to the embodiments and may be variously modified within a range which does not depart from the technical spirit of the present invention. Therefore, it should be understood that the embodiments described above are exemplary from every aspect and are not restrictive. It should be construed that the scope of the present invention is defined by the below-described claims instead of the detailed description, and the meanings and scope of the claims and all variations or modified forms inferred from their equivalent concepts are included in the scope of the present invention.

## Claims

1. A solar cell comprising:
a semiconductor substrate;
a first semiconductor layer provided on one surface of the semiconductor substrate;
a second semiconductor layer provided on one surface of the first semiconductor layer;
a third semiconductor layer provided on one surface of the second semiconductor layer;
a first transparent conductive layer provided on one surface of the third semiconductor layer; and
a first electrode provided on one surface of the first transparent conductive layer,
wherein the second semiconductor layer comprises a p-type semiconductor material, and the third semiconductor layer comprises a p-type semiconductor material including tungsten (W).

2. The solar cell of claim 1, wherein a bandgap of the third semiconductor layer is less than a bandgap of the second semiconductor layer, and a valence band maximum energy level of the third semiconductor layer is lower than a valence band maximum energy level of the second semiconductor layer.

3. The solar cell of claim 1, wherein the first transparent conductive layer is formed of a transparent oxide film including indium.

4. The solar cell of claim 1, wherein the first semiconductor layer is formed of an intrinsic amorphous silicon layer.

5. The solar cell of claim 1, further comprising:
a fourth semiconductor layer provided on the other surface of the semiconductor substrate;
a fifth semiconductor layer provided on a surface of the fourth semiconductor layer;
a second transparent conductive layer provided on a surface of the fifth semiconductor layer; and
a second electrode provided on a surface of the second transparent conductive layer,
wherein the fifth semiconductor layer comprises an n-type semiconductor material including tin (Sn).

6. The solar cell of claim 5, wherein the fourth semiconductor layer is formed of an intrinsic amorphous silicon layer,
an n-type amorphous silicon layer is further provided between the fourth semiconductor layer and the fifth semiconductor layer, and
a bandgap of the fifth semiconductor layer is greater than a bandgap of the n-type amorphous silicon layer, and a conduction band minimum energy level of the fifth semiconductor layer is higher than a conduction band minimum energy level of the n-type amorphous silicon layer.

7. The solar cell of claim 5, wherein a thickness of the fifth semiconductor layer is formed within a range of 10 Å to 100 Å, and a thickness of the second transparent conductive layer is formed within a range of 100 Å to 500 Å.

8. The solar cell of claim 5, wherein the second transparent conductive layer is formed of a transparent oxide film including indium, and a concentration of indium in the transparent oxide film is within a range of 1 at% to 5 at%.

9. The solar cell of claim 8, wherein the first transparent conductive layer is formed of a transparent oxide film including indium, and a content of indium included in the first transparent conductive layer is higher than a content of indium included in the second transparent conductive layer.

10. The solar cell of claim 5, further comprising a perovskite solar cell provided between the second transparent conductive layer and the second electrode,
wherein the perovskite solar cell comprises:
a first conductive charge transporting layer formed of a hole transporting layer contacting the second transparent conductive layer;
a light absorption layer formed of a perovskite compound provided on the first conductive charge transporting layer; and
a second conductive charge transporting layer formed of an electron transporting layer provided on the light absorption layer.

11. A method of manufacturing a solar cell, the method comprising:
a process of forming a first semiconductor layer on one surface of a semiconductor substrate;
a process of forming a second semiconductor layer on one surface of the first semiconductor layer;
a process of forming a third semiconductor layer on one surface of the second semiconductor layer;
a process of forming a first transparent conductive layer on one surface of the third semiconductor layer; and
a process of forming a first electrode on one surface of the first transparent conductive layer,
wherein the process of forming the third semiconductor layer comprises a process of forming a p-type semiconductor material including tungsten (W), and
the process of forming the third semiconductor layer and the process of forming the first transparent conductive layer comprise a continuous process performed in the same process equipment.

12. The method of claim 11, wherein the process of forming the first transparent conductive layer comprises a process of forming a transparent oxide film including indium.

13. The method of claim 11, further comprising:
a process of forming a fourth semiconductor layer provided on the other surface of the semiconductor substrate;
a process of forming a fifth semiconductor layer provided on a surface of the fourth semiconductor layer;
a process of forming a second transparent conductive layer provided on a surface of the fifth semiconductor layer; and
a process of forming a second electrode provided on a surface of the second transparent conductive layer,
wherein the process of forming the fifth semiconductor layer comprises a process of forming an n-type semiconductor material including tin (Sn), and
the process of forming the fifth semiconductor layer and the process of forming the second transparent conductive layer comprise a continuous process performed in the same process equipment.

14. The method of claim 13, wherein the process of forming the fifth semiconductor layer comprises a process of forming SnO by supplying a material including Sn and a material including oxygen (O) in a chamber, and
the process of forming the second transparent conductive layer comprises a process of forming a transparent oxide film including indium by supplying the material including Sn, the material including O, and a material including indium in the chamber.

15. The method of claim 13, wherein the process of forming the fifth semiconductor layer and the process of forming the second transparent conductive layer comprise forming an SnO layer by supplying a material including Sn and a material including O in a chamber, and additionally doping indium on the SnO layer in the chamber to form the fifth semiconductor layer formed of an indium-undoped SnO layer and the second transparent conductive layer formed of a transparent oxide film including indium based on doping of indium.

16. The method of claim 13, further comprising a process of forming an n-type amorphous silicon layer, between the process of forming the fourth semiconductor layer and the process of forming the fifth semiconductor layer,
wherein the process of forming the fourth semiconductor layer and the process of forming the n-type amorphous silicon layer comprise a continuous process performed in the same process equipment.

17. The method of claim 13, further comprising a process of forming a perovskite solar cell between the second transparent conductive layer and the second electrode,
wherein the process of forming the perovskite solar cell comprises:
a process of forming a first conductive charge transporting layer formed of a hole transporting layer contacting the second transparent conductive layer;
a process of forming a light absorption layer, formed of a perovskite compound, on the first conductive charge transporting layer; and
a process of forming a second conductive charge transporting layer, formed of an electron transporting layer, on the light absorption layer.
